# EUROPEAN PATENT APPLICATION

(11) **EP 1 267 483 A2**
(43) Date of publication of application: **18.12.2002**
(21) Application number: 02012745.2
(22) Date of filing: 07.06.2002
(51) Int. Cl.: H03F 1/02

(54) **Asymmetrically biased high linearity balanced amplifier**

(30) Priority: 08.06.2001 US 878113
(71) Applicant: TRW Inc., Redondo Beach, California 90278 (US)
(72) Inventor: Kobayashi, Kevin W., Torrance, CA 90505 (US)
(74) Representative: Schmidt, Steffen J., Dipl.-Ing.

(57) **Abstract**

A microwave amplifier and more particularly to a microwave amplifier configured as a Doherty amplifier. In particular, the amplifier includes a carrier amplifier, a peak amplifier a Lange coupler at the input of the amplifiers and quarter wave amplifier at the output of the amplifiers. In order to improve isolation between the amplifiers to minimize the dependence of each amplifier's inter-modulation (IM) performance on the others, matching networks are provided, coupled to the output of the amplifiers. In addition, the microwave power amplifier includes electronic tuning which allows for improved inter-modulation distortion over a wide input power dynamic range, which allows the IM performance of the microwave amplifier to be adjusted for the operating frequency of the amplifier.

## Description

### BACKGROUND OF THE INVENTION

### 1. Field of the Invention

The present invention relates to a power amplifier and more particularly to a microwave power amplifier topology that provides high output power with good phase and amplitude linearity at relatively high output power levels across a relatively wide frequency range.

### 2. Description of the Prior Art

Radio frequency and microwave communication systems are known to place ever-increasing demands on the linearity and efficiency of power amplifiers. Unfortunately. conventional power amplifiers operate at maximum efficiency at or near saturation. Thus, in order to accommodate communication signals having varying amplitudes, systems utilizing conventional power amplifiers normally operate at less than peak efficiency for a substantial portion of the time.

In order to solve this problem, so-called Doherty amplifiers have been developed. Doherty amplifiers were first introduced by an inventor having the same name in; "Radio Engineering Handbook" 5^{th} edition, McGraw Hill Book Company, 1959, pp. 18-39, as well as U.S. Patent No. 2,210,028. The standard topology for a Doherty amplifier includes a carrier amplifier, operated in a Class AB mode and peak amplifier operated in a Class C mode. A quadrature Lange coupler is used at the input so that the carrier amplifier and peak amplifier signals will combine in phase. A quarter wave amplifier is provided at the outputs of the amplifier. In essence, the carrier amplifier operates at a point where the output begins to saturate for maximum linear efficiency. The peak amplifier is used to maintain the linearity of the output signal when the carrier amplifier begins to saturate.

Such Doherty amplifiers have been known to be used in various microwave and RF applications. Examples of such applications are disclosed in U.S. Patent NO. 5,420,541; 5,880,633; 5,886,575, 6,097,252 and 6,133,788. Examples of such Doherty amplifiers are also disclosed in "A Fully Integrated Ku-Band Doherty Amplifier MMIC," by C. F. Campbell, IEEE Microwave and Guided Wave Letters, Vol. 9, No. 3, March 1999, pp. 114-116; "An 18-21 GHz InP DHBT Linear Microwave Doherty Amplifier", by Kobayashi et al, 2000 IEEE Radio Frequency Integrated Circuits Symposium Digest of Papers, pages 179-182; "A CW 4 Ka-Band Power Amplifier Utilizing MMIC Multichip Technology," Matsunaga, et al., 1999, GaAs IC Symposium Digest, Monterey, California, pp. 153-156, all hereby incorporated by reference.

The systems mentioned above are known to provide relatively good phase linearity and high efficiency since the power amplifier need only respond to constant or near constant RF amplitude envelopes. Unfortunately, the RF amplitude envelopes of multi-carrier signals (multifrequency signals) change with time as a function of the bandwidth. Power amplifiers utilized in multi-carrier systems must be able to operate over a relatively large instantaneous bandwidth while providing relatively good phase linearity for RF signals having non-constant envelopes. One attempt to provide a power amplifier suitable for multi-carrier applications is disclosed in U.S. Patent No. 5,568,086. The '086 patent discloses a Doherty-type amplifier and includes a carrier amplifier and a peak amplifier. The amplifier is configured such that the carrier amplifier saturates at half of its maximum power level. In addition, the amplifier includes a number of phase shifting components.

There are several drawbacks to the multi-carrier Doherty amplifier disclosed in the '086 patent. First, the carrier amplifier is only operated to one half of its maximum power capability, which results in lower efficiency and linearity. Second, the power amplifier is relatively complex including a number of phase shifting components. Thus, there is a need for simplified multi-carrier microwave amplifiers, which provide good phase and amplitude linearity at relatively high output power levels across a relatively wide frequency range.

### SUMMARY OF THE INVENTION

The present invention relates to a microwave amplifier and more particularly to a microwave amplifier configured as a Doherty amplifier. The amplifier includes a carrier amplifier, a peak amplifier, a Lange coupler at the input of the amplifiers and a quarter wave amplifier at the output of the amplifiers. In order to improve isolation between the amplifiers to minimize the dependence of each amplifier's inter-modulation (IM) performance on the others, matching networks are provided, coupled to the output of the amplifiers. In addition, the microwave power amplifier includes electronic tuning which allows for improved inter-modulation distortion over a wide input power dynamic range which allows the IM performance of the microwave amplifier to be adjusted for the operating frequency of the amplifier.

### DESCRIPTION OF THE DRAWINGS

These and other advantages of the present invention will be readily understood with reference to the following specification and attached drawing wherein:

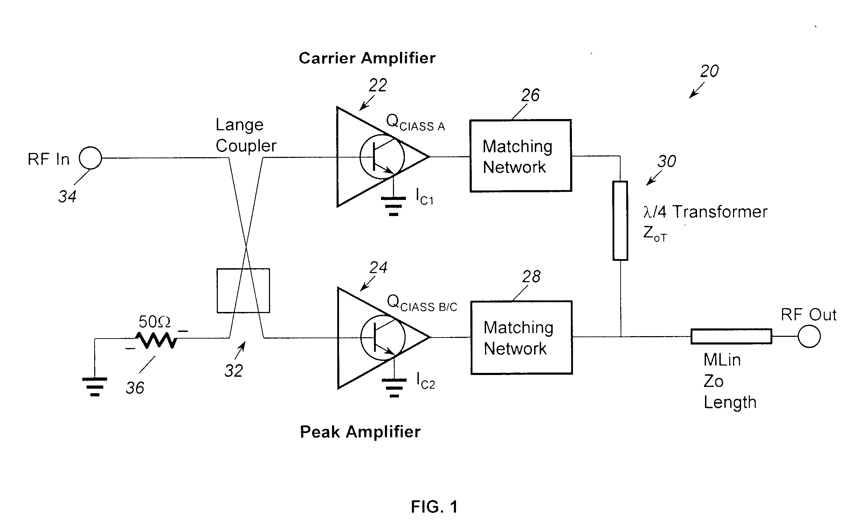

FIG. 1 is a schematic diagram of the microwave power amplifier in accordance with the present invention.
FIG. 2 is a graphical representation of the output power as a function of the gain for various biasing points of the carrier and peak amplifiers forming the microwave power amplifier in accordance with the present invention.
FIGs. 3A-3C illustrate matching networks for use with the present invention.
FIGs. 4A-4B illustrate biasing networks for use with the carrier and peak amplifiers of the present invention.

### DETAILED DESCRIPTION OF THE INVENTION

The present invention relates to a microwave power amplifier configured as a Doherty amplifier, generally identified with the reference numeral 20. The microwave power amplifier 20 includes a carrier amplifier 22 and a peak amplifier 24. Both the carrier amplifier 22 and the peak amplifier may be formed from heterojunction bipolar transistors (HBT) 22 and in particular as a prematched 1.5 x 30 µm² x four finger DHBT device with a total emitter area of 180 µm². An example of such a device is disclosed in "An 18-21 GHz InP DHBT Linear Microwave Doherty Amplifier", by Kobayashi et al, 2000 IEEE Radio Frequency Integrated Circuits Symposium Digest of Papers, pages 179-182, hereby incorporated by reference. Methods for fabricating HBTs are extremely well known in the art, for example, as disclosed in commonly owned U.S. Patent Nos. 5,162,243; 5,262,335; 5,352,911; 5,448,087; 5,672,522; 5,648,666; 5,631,477; 5,736,417; 5,804,487; and 5,994,194, all hereby incorporated by reference.

In order for the output signals from the carrier amplifier 22 and the peak amplifier 24 to be in phase at the output, a Lange coupler 32 is provided. One input terminal of the Lange coupler 32 is used as a RF input port 34. The other input terminal is terminated to an input resistor 36. One output terminal of the Lange coupler 32 is coupled to the input of the carrier amplifier 22 while the other output terminal is coupled to the input to the peak amplifier 24. A 1/4-wave impedance transformer having a characteristic impedance Zₒ = 2R_{L} + Rₒₚₜ is provided at the output of the amplifiers 22 and 24. An output terminal of the power amplifier 20 is terminated to load impedance R_{L}. Both the carrier amplifier 22 and the peak amplifier 24 are configured to deliver maximum power when the load impedance R_{L} is Rₒₚₜ.

The carrier amplifier 22 is operated as a Class A amplifier while the peak amplifier 24 is operated as a Class B/C amplifier. In order to improve the isolation between the carrier amplifier 22 and the peak amplifier 24, for example, when the carrier amplifier 22 is biased as a Class A amplifier and the peak amplifier 24 is biased between Class B and C, matching networks 26 and 28 are coupled to the output of the carrier amplifier 22 and the peak amplifier 24. As such, the impedance of each amplifier stage will not contribute to the inter-modulation (IM) performance of the other stage.

In order to fully understand the invention, a discussion of known Doherty type amplifiers is presented first. More particularly, as set forth in: "A Fully Integrated Ku-Band Doherty Amplifier MMIC," supra, the loading impedance presented to the carrier and peak amplifiers of known Doherty amplifiers is a function of the output power delivered by the peak amplifier. During low input drive levels (i.e. levels in which the RF input amplitude is low), the peak amplifier is turned off resulting in a configuration in which the carrier amplifier saturates at a relatively low input drive level. As such, the carrier amplifier will result in a higher power added efficiency (PAE) at lower input power levels. As the input power level increases, the peak amplifier will begin to turn on as the power delivered by the peak amplifier increases. The load presented to the carrier amplifier decreases allowing the carrier amplifier 24 to increase to provide power to the load.

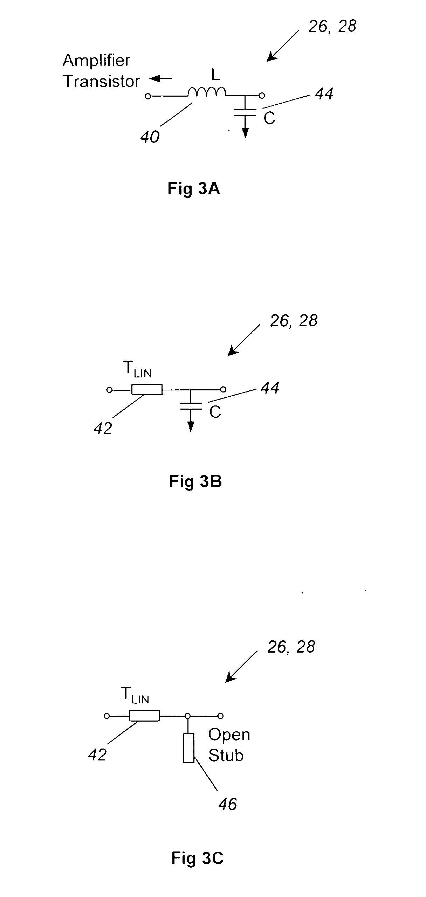

The matching networks 26 and 28 are serially coupled to the outputs of the carrier and peak amplifiers 22 and 24, respectively. These matching networks 26 and 28 may be provided as low pass networks, for example, as illustrated in Figs. 3A-3C. As shown in Figs. 3A-3C, the matching networks 26, 28 may be implemented as a series inductance 40 or transmission line 42 and a shunt capacitance 44 or open stub 46. In operation, when the carrier amplifier 22 is on and the peak amplifier 24 is off, the matching networks 26, 28 provide a relatively high impedance (mainly due to the high impedance transmission line 42 or inductance 40) such that the peak amplifier 24 does not load down the carrier amplifier 22, operating in class A, to achieve optimum linearity and efficiency under low input power conditions.

The theory of operation of the matching networks 26, 28 is contrary to the operation of matching networks used for conventional power amplifiers. More particularly, typically in a power amplifier application, a low impedance series transmission line or low impedance shunt capacitance or open stub is provided at the output of the power transistor in order to efficiently transform the low impedance of the power transistor to a higher manageable impedance as well as provide isolation between the amplifying transistors.

In accordance with another aspect of the invention, the carrier amplifier 22 and peak amplifier 24 are DC biased tuned so that the optimum IM performance can be achieved for the specific operating frequency of the amplifier. For example, for a 21 GHz carrier frequency, a microwave amplifier 20 can be DC biased tuned to minimize the IM performance at 20 GHz.

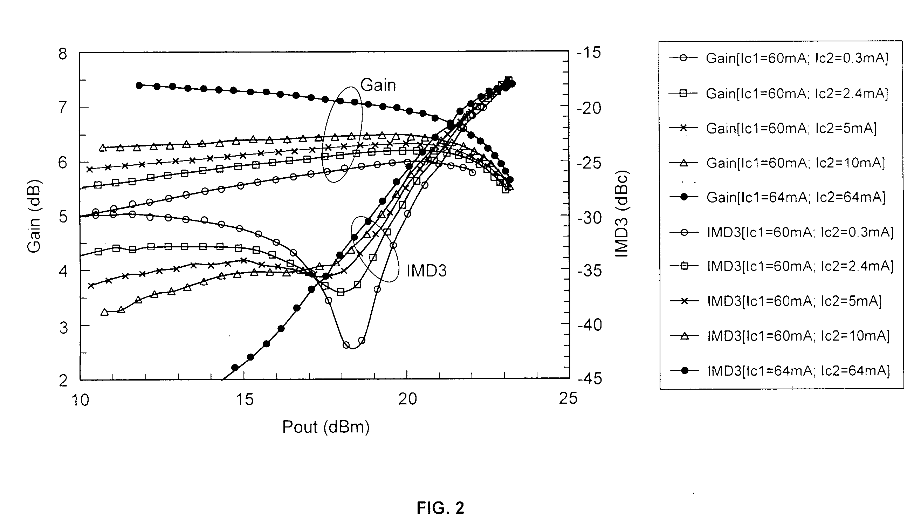

FIG. 2 illustrates the measured gain and IM3 (third order modulation products) as a function of output power at 21 GHz for various biasing conditions of the amplifier 20. In particular, the IM3 and gain is illustrated for Class A bias operation (Icl = 64mA; Ic2 = 64 mA) as well as asymmetric bias conditions. In particular, the asymmetrically bias conditions are illustrated when the peak amplifier 24 is off and the carrier amplifier 22 is biased in a Class A mode (IC1 = 60-64 mA) and the peak amplifier is bias in Class B (IC2 = 0.3-10 mA). As illustrated in FIG. 2, adjustment of the peak amplifier bias current (IC2) allows the shape and performance of the IM3 linearity ratio to be significantly improved across a relatively wide output power range. During a biasing condition (i.e. Ic1 = 60 mA; Ic2 = 0.3 mA), when the peak amplifier is nearly shut off, the microwave power amplifier 20 in accordance with the present invention achieves a relatively dramatic improvement of the IM3 ratio resulting in a deep IM3 cancellation of about -43 dBc. For multi-carrier communication systems, an IM3 ratio of about 30 dBc is a typical requirement for linearity. With such linearity, the microwave power amplifier 20 is able to achieve about 20% power added efficiency (PAE) and an output power of about 20.1 dBm which is a significant improvement compared to conventional linear Class A bias mode which achieves about 13% PAE and 18.8 dBm output power for the same linearity.

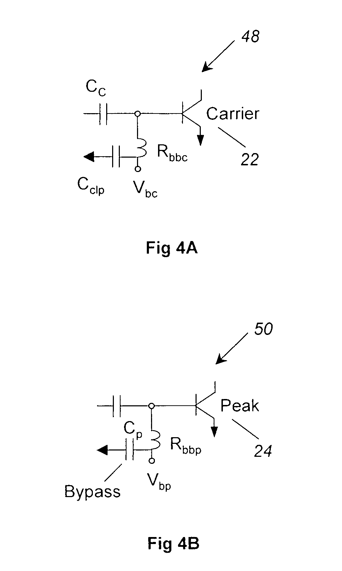

Various biasing networks can be used for tuning the carrier and peak amplifiers 22 and 24. Exemplary biasing networks 48 and 50, are illustrated in Figs. 4A and 4B. Each of the biasing networks 48, 50 include a biasing resistor, R_{bbc} or R_{bbp}, coupled to an external source of DC, V_{bc} or V_{bp}. A low pass capacitor C_{clp} or Cₚₗₚ is coupled to the biasing resistor, R_{bbc} or R_{bbp}, the external source DC voltage, V_{bc} or Vᵥₚ, and ground to filter out noise. Coupling capacitors C_{cc}, C_{cp} may be used to couple the carrier and peak amplifiers 22 and 24 to the Lange coupler 32.

The biasing circuits, for example, the biasing circuits 48 and 50, enable one or the other or both the carrier amplifier 22 and peak amplifier to be electronically turned. In the case of the exemplary biasing circuits 48 and 50, illustrated in FIGs. 4A and 4B, respectively, the biasing of the carrier and peak amplifiers 22 and 24 may be varied by varying the amplitude of the external DC voltage V_{bc}, V_{bp} coupled to the input of the carrier and peak amplifiers 22 and 24.

The electronic tuning of the carrier and peak amplifiers 22 and 24, as provided by the biasing circuits 48 and 50, provides many important advantages in accordance with the present invention. First, the electronic tuning allows the carrier and peak amplifiers 22 and 24 to be tuned for optimal linearity. Secondly, electronic tuning allows for improved intermodulation distortion over a relatively wide input power range. As such, the amplifier 20 can be tuned such that the operating range (i.e. carrier amplifier frequency) has the maximum IM rejection possible. Moreover, as discussed above, the relatively high impedance of the matching networks 26 and 28 results in the virtual isolation of the IM products of the carrier amplifier 22 and peak amplifier 24, therefore, providing less IM products. Lastly, the electronic tuning can also be used to provide gain expansion and phase compression for use in predistortion linearization applications.

Obviously, many modification and variations of the present invention are possible in light of the above teachings. For example, thus, it is to be understood that, within the scope of the appended claims, the invention may be practiced otherwise than as specifically described above.

What is claimed and desired to be secured by Letters Patent of the United States is:

## Claims

1. A microwave power amplifier comprising:
an input RF port
a carrier amplifier having a first input and a first output
a peak amplifier having a second input and a second output, said carrier amplifier and said peak amplifier being symmetrically biased;
a coupling device for coupling said first and second inputs of said carrier amplifier and said peak amplifier to said RF input port; and
an output terminal, said first and second outputs coupled to said output terminal.

2. The microwave power amplifier as recited in claim 1, wherein one or the other of said carrier and peak amplifiers includes a biasing network configured to enable the biasing of said one or the other of said carrier and peak amplifiers to be varied.

3. The microwave power amplifier as recited in claim 2, wherein said biasing network includes an external source of DC voltage which enables the biasing of said one or the other of said carrier and peak amplifiers to be varied by varying the amplitude of said DC voltage to provide electronic tuning of said amplifier; and wherein the other of said one or the other of said carrier and peak amplifiers includes a biasing network which provides electronic tuning of the other of said one or the other of said carrier amplifier and said peak amplifier.

4. The microwave power amplifier as recited in claim 1, further including one or more matching networks; and wherein said one or more matching networks include a series impedance selected to prevent loading of said carrier amplifier by said peak amplifier.

5. The microwave power amplifier as recited in claim 4, wherein said series impedance is a transmission line or is an inductance.

6. The microwave power amplifier as recited in claim 4, wherein said one or more matching networks also includes a shunt impedance, coupled to said series impedance.

7. The microwave power amplifier as recited in claim 6, wherein said shunt impedance is a capacitor, or is an open stub.

8. The microwave power amplifier as recited in claim 4, further including an impedance transformer coupled between said one or more matching networks and said RF output terminal.

9. The microwave power amplifier as recited in claim 8, further including an output impedance coupled between said RF output terminal and said impedance transformer.

10. The microwave power amplifier as recited in claim 1, wherein said coupler is a Lange coupler having first and second input terminals and first and second output terminals, said first input terminal defining said RF input port and said second input terminal coupled to an input termination impedance.
